Europäisches Patentamt

European Patent Office

Office européen des brevets

(19)

(11) **EP 1 246 370 A1**

(12) **EUROPEAN PATENT APPLICATION**

(43) Date of publication:
**02.10.2002 Bulletin 2002/40**

(51) Int Cl.[7]: **H03M 13/15**, H03M 13/45

(21) Application number: **01302867.5**

(22) Date of filing: **28.03.2001**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **LUCENT TECHNOLOGIES INC.
Murray Hill, New Jersey 07974-0636 (US)**

(72) Inventors:
  • **Bayer, Ludwig Dr.
    Bavaria 90542 (DE)**

  • **Buerner, Thomas
    91207 Lauf (DE)**
  • **Dohmen, Ralf
    Nuernberg, Bavaria 90459 (DE)**

(74) Representative: **Sarup, David Alexander et al
Lucent Technologies UK Limted,
5 Mornington Road
Woodford Green, Essex IG8 OTU (GB)**

(54) **Decoding method for block codes used for the purpose of channel coding**

(57)    The invention relates to decoding an algebraic block code used for the purpose of channel coding. One object of the invention is to indicate an efficient way, which is simplified by comparison with the prior art, for decoding algebraic block codes used for channel coding for digital data transmission. The invention proposes for this purpose a method, a receiving device and a computer program in such a way that a received word (r) is sampled at predeterminable interpolation points ($\alpha^0$, ..., $\alpha^{n-1}$) in order to obtain symbols ($r^0$, ...,. $r^{n-1}$) contained in the received word (r), coefficients ($R_1$) for the purpose of forming a syndrome polynomial ($R^{[1]}(X)$) are obtained by applying a discrete Fourier transformation to the symbols ($r^0$,....,. $r^{n-1}$) and an error position search is carried out on the basis of the syndrome polynomial ($R^{[1]}(X)$) with the defined introduction of erasures.

FIG. 1

**Description**

The invention relates to a method, a receiving device and a computer program for decoding an algebraic block code used in a digital transmission system for the purpose of channel coding.

As is generally known, algebraic block codes are used for the purpose of raising the reliability in digital transmission systems. In this case, specific code instructions of the information to be sent, that is to say to be transmitted, are used to add redundancy, in order thereby to detect at the receiving end errors arising during transmission, and to correct them, if appropriate.

Furthermore, of the algebraic block codes the Reed-Solomon code (RS code) developed by Irving Reed and Gustav Solomon has developed to one of the most used codes in the fields of channel coding. For the purpose of further understanding of the Reed-Solomon code, reference may be made in this regard to the publication entitled "Polynomial Codes over Certain Finite Fields" which appeared in 1960 in Volume 8 on pages 300 to 304 in the series SIAM Journal of Applied Mathematics by Reed and Solomon, the subject matter of which is to be fully regarded as part of the disclosure content of the present application.

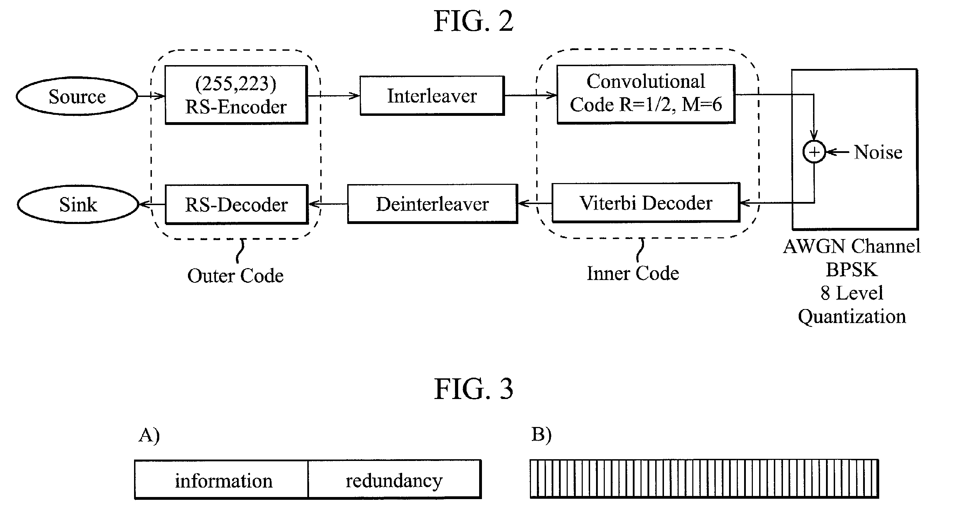

Reed-Solomon codes or RS codes are suitable, for example, in particular for correcting burst errors, such as occur inter alia, for example, in the case of scratches in audio CDs. Furthermore, the application of a Reed-Solomon code has proved to be advantageous in the case of concatenated codes. Reference may be made, in particular, in this regard to the publication by J. Hagenauer, E. Offer and L. Papke which appeared in 1993 under the title of "Improving the Standard Coding System for Deep Space Missions" in Proceedings of IEEE International Conference on Communications on pages 1092 to 1097 and in the case of which the concatenation of an internal convolution code with the aid of an external Reed-Solomon code was investigated (Figure 2). In this case, it was also shown that the bit error rate can be substantially reduced when reliability information is generated for the received bits or symbols and adopted, and the decoding is, moreover, carried out by iteration, that is to say after decoding of the external and the internal codes the inner code is once again decoded, the outer one is subsequently further decoded, and so on until the maximum number of iterations is reached, or no error is any longer discovered. The content of the abovementioned publication is taken fully in reference as part of the disclosure of the present invention.

One possibility of making use in decoding of reliability information generated in relation to received symbols is the successive erasure decoding (SED), which is known to the person skilled in the art.

If a code word comprises, for example, a length of n symbols with information which is embedded therein, is to be sent and has a length of k symbols, a code word formed using the Reed-Solomon code permits a correction of t = int ((n-k)/2)) symbol errors. Note that a code word formed need not necessarily be constructed systematically as illustrated in Figure 3a, that is to say the code word generated as a consequence of the coding need not contain in clear text the information originally to be sent. The code word can also be of nonsystematic design, as illustrated in Figure 3b, that is to say can contain the information and redundancy in a mixed fashion.

Moreover, it has proved in practice that erasure decoding can be carried out in a simple way in the case of Reed-Solomon codes. In this case, symbols recognized as unreliable from the consideration of the generated reliability information is marked as erasure, in order to indicate that an error position is already recognized as such but that the corresponding error value is still unknown. The effectiveness of such an erasure decoding can be substantially raised when it is carried out successively. For this purpose, it is customary firstly to decode over all received symbols, and erasures are introduced upon the occurrence of a decoding failure until the decoding has succeeded. If the number of erasures introduced reaches a specific, prescribed maximum upper bound without the decoding thereby being possible, decoding failure is recognized.

So far, in the case of such methods for successive erasure decoding it has been necessary to go through a complete decoding in each step. In other words, the decoding is firstly carried out without erasures, subsequently with two, thereafter with four, etc., and this requires an increased outlay on time or, in the case of correspondingly many decoding devices operating in parallel, an increased demand on resources. For this purpose, it is customary in practice to dispense with the method for successive erasure decoding.

A method with the aid of which the previously required multiplicity of decodings can be reduced to a single one has been published by U. Sorger in March 1993 in IEEE, Transactions on Information Theory, under the title of "A new RS-Code decoding algorithm based on Newton's interpolation" on pages 358 to 365, and incorporated in 1994 into his dissertation, which is fully incorporated by reference for the purpose of better understanding of the present invention. This method disclosed by U. Sorger is based substantially on Newton's interpolation, the received symbols being sorted in terms of their reliability. For the decoding, the maximum number of erasures is thereupon firstly active, and subsequently two erasures are removed in each step, and the decoding result is stored. At the end, that is to say when all erasures have been removed, the number of the decoding results buffered after each completed decoding is used to determine with the aid of weighting criteria which result is to be regarded as the best, that is to say is to be used as final decoding result for further processing. This method is denoted as generalized minimum distance (GMD) decoding.

Although this method does already constitute a simplification by comparison with a multiplicity of decoding devices operating in parallel, the method disclosed by Sorger continues to exhibit enormous complexity, essentially because of the Newton's interpolation required therein, particularly by comparison with conventional error-only decoding (EOD) methods. Furthermore, this complexity and the disadvantages associated therewith are essentially not influenced by the approach, proposed moreover in the dissertation by U. Sorger, of firstly decoding over all Newton's coefficients and subsequently introducing the erasures.

One object of the invention therefore consists in indicating an efficient way, which is simplified by comparison with the prior art, for successive erasure decoding of algebraic block codes used for channel coding for digital data transmission.

The solution of the task according to the invention is characterized by a method, a receiving device and a computer program having the features of Claims 1, 9 and 13, respectively.

Advantageous and preferred developments are the subject matter of the subclaims.

According to the invention, it is provided in the case of a transmission system for digital data transmission, in which channel coding is undertaken by means of an algebraic block code, to make use of a received word, preferably by applying a discrete Fourier transformation, to generate coefficients of an interpolating receiving polynomial and, on the basis of the receiving polynomial, to carry out an error position search starting from known, code-specific zero points and subsequent defined introduction of erasures.

In a preferred way, the transmission system according to the invention uses the current Reed-Solomon code or related codes such as, in particular, the BCH codes, a decoding device having proved itself in practice which carries out the procedure according to the invention in two stages. Thus, it is provided to carry out an error position search firstly on the basis of an algebraic decoding method which is known per se and executes an error-only decoding, in particular on the basis of a Berlekamp-Massey algorithm or variants thereof. The decoding can be continued subsequently through defined introduction of erasures. For this purpose, it is provided, in particular, to use the code-specific zero points from the receiving polynomial to generate an error position polynomial which is functionally connected, and to carry out the introduction of erasures in the error position polynomial, which then becomes the erasure and error position polynomial.

The introduction of the erasures is performed successively in a preferred development, reliability information expediently being obtained by the receiving device itself in a way known per se for the symbols to be erased with reference to the symbols, contained at the individual interpolation points, of the received word.

If individual decoding results are advantageously buffered, they can, if a maximum available number of erasures has not yet been reached, be made available to a generalized minimum distance decoding (GMD).

If the maximum number of erasures which can be introduced has been reached, without a unique decoding being possible, the decoding is terminated with decoding failure.

Thus, the combination according to the invention of partial method steps known per se substantially simplifies with reference to complexity the mechanism required for decoding, including subsequent error correction, in the form of the necessary hardware and/or software, such that, for example, a decoding device implemented as an integrated circuit can be designed with a greatly reduced number of gates.

As has already been shown by Hagenauer, in the case of application for concatenated codes, in particular with an internal soft output decoder, for example based on the soft output Viterbi algorithm, and iterated decoding, the invention also permits a substantial growth in benefit with reference to the bit error rate if, instead of an error-only decoder, use is made of a receiving device having a decoding device in accordance with the invention as external decoding device.

The invention is described in detail by way of example below and with reference to the attached drawing, in which:

Figure 1     shows a diagrammatic flowchart of an exemplary embodiment of a decoding mechanism in accordance with the invention,

Figure 2     shows a block diagram of a standard coding system in accordance with the publication by Hagenauer et al., referred to,

Figure 3a     shows a sketch of the principle of a systematically constructed code word, in which the information and the redundancy are present separately from one another, and

Figure 3b     shows a sketch of the principle of a non-systematically constructed code word in which the information and the redundancy are mixed.

It may firstly be assumed in general terms for the following description that for the purpose of channel coding of an item of information to be sent, use is made for a digital transmission system, for example a mobile radio system, of a cyclic (n, k) Reed-Solomon code in the narrower sense, that is to say n=q-1 in the GF(q) (Galois field). The number of the symbols comprised over all by the code word formed is therefore defined by "n", and the number of the symbols of the information to be sent and embedded in the code word is defined by "k". The number of the correctable errors is therefore yielded as t = int ((n-k)/2)), it being possible, as an alternative, to introduce two erasures for each correctable error.

If $\alpha$ represents a primitive nth unit root in GF(q), it is possible, as is known per se to the person skilled in the art in this field, to evaluate and transmit a polynomial of (k-1)th degree in $\alpha^0$, .., $\alpha^{n-1}$ in order to form the code word.

Consequently, a transmit code word "c" emitted by a transmitting device of the transmission system has a symbol sequence $c^0$,...., $c^{(n-1)}$, with element $c^0$,..., $c^{(n-1)}$ from GF(q). A received word "r" which differs from the sent code word "c" by the error word "e" is then obtained in an assigned receiving device after transmission of the sent code word c. In general terms, it holds that: r = c + e.

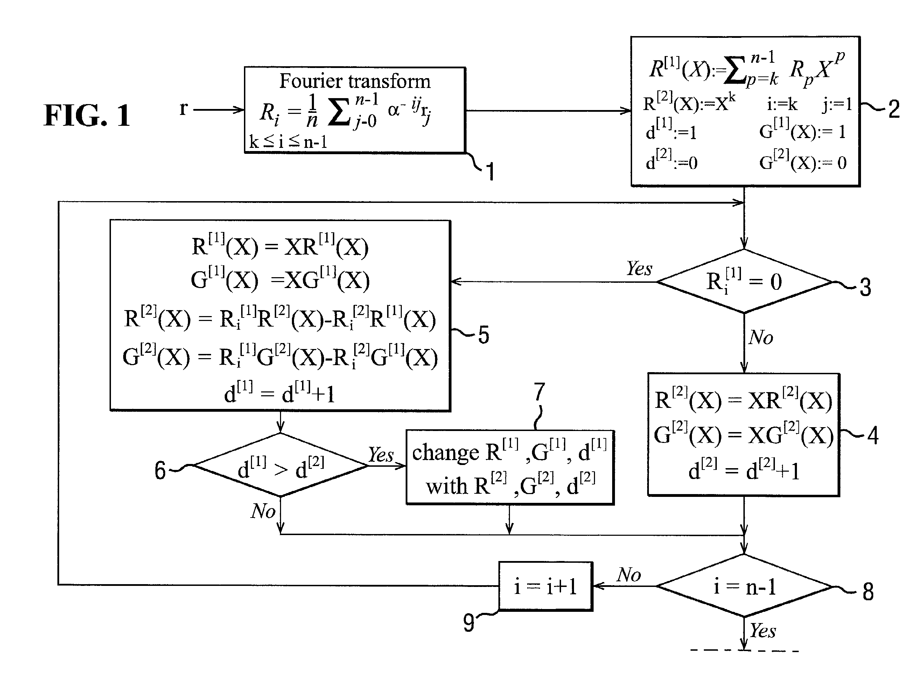

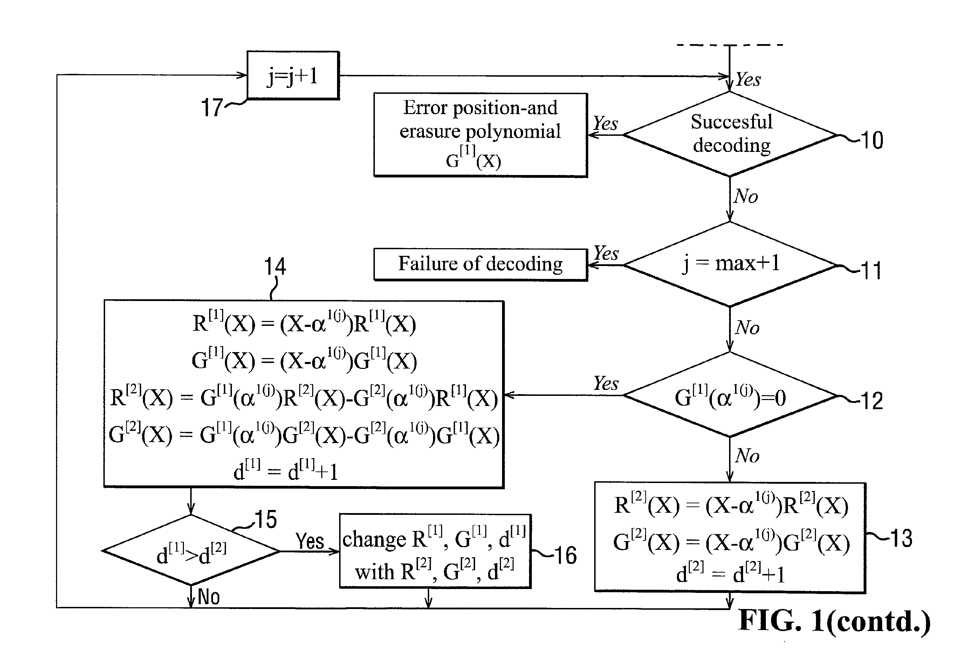

With subsequent reference to Figure 1, after the transmission a received word "r" with symbols $r^0$,.., $r^{n-1}$ sampled at the interpolation points $\alpha^0$,.., $\alpha^{n-1}$ is therefore present at the receiving device.

As marked by the reference numerals 1 and 2 in Figure 1, the first step in initializing a decoding mechanism in accordance with the invention is to use the hardware and/or software implemented in the receiving device to form the coefficients $R_i$ of an interpolating receiving polynomial

$$R(X) \ = \ \sum_{i=0}^{n-1} R_i \ X^i \qquad\qquad (1)$$

by applying a Fourier transformation via the rule

$$R_i \ = \ \frac{1}{n} \sum_{j=0}^{n-1} \alpha^{-ij} \ r_j \qquad\qquad (2)$$

in which case $0 \le i \le (n-1)$ holds.

In the present case, in which a code word is produced by evaluating a coding polynomial of (k-1)th degree, only the coefficients $R_k$ to $R_{n-1}$ are of interest for the algorithm, since these coefficients depend exclusively on transmission errors and not on the word sent.

The part $R^{[1]}(X)$ of the receiving polynomial which is relevant to the algorithm is yielded subsequently from the coefficients $R_i$ via the rule

$$R^{[1]}(X) \ := \ \sum_{p=k}^{n-1} R_p \ X^p \qquad\qquad (3)$$

and is denoted as a syndrome polynomial.

Furthermore, for the purpose of initializing the decoding mechanism an auxiliary polynomial $R^{[2]}(X) := X^k$ is defined, and the running variables are set at i := k and j := 1, respectively, for the respective position in the syndrome and the number of erasures.

Finally, an error position polynomial $G^{[1]}(X) := 1$ is defined with an associated degree $d^{(1)} := 0$ and an error positioned auxiliary polynomial $G^{[2]}(X) := 0$ with an associated degree $d^{[2]} := 0$ is defined.

As is described in detail below, the decoding mechanism of the receiving device is designed in such a way that error position only decoding is performed in the first stage. For the case in which the syndrome polynomial $R^{[1]}(X)$ is already "zero" at the initialization, no errors occur during the transmission of information, and the subsequently described decoding is aborted at this juncture.

Following the initialization, the error-only decoding is then carried out in a way known per se to the person skilled in the art and essentially follows the Berlekamp-Massey algorithm in the present example.

For this purpose, the individual coefficients $R_i$ [1] are firstly investigated in a stepwise fashion and marked by the reference numeral 3 in Figure 1 as to whether they are "zero". If the coefficient to be investigated $R_i$ [1] = 0, no change takes place at the error position polynomial and syndrome polynomial, but, as marked by the reference numeral 4 in Figure 1, the coefficients of the auxiliary polynomial $R^{[2]}(X)$ and of the error position auxiliary polynomial $G^{[2]}(X)$ are displaced to the right by one position in each case by multiplying by the unknown "X", and the degree $d^{[2]}$ of the error position auxiliary polynomial is consequently increased by one.

If the coefficient $R_i^{[1]}$ to be investigated does not vanish, the syndrome polynomial $R^{[1]}(X)$ and the assigned error position polynomial $G^{[1]}(X)$ are, by contrast, displaced to the right by one position in order then to obtain "zero" for the coefficient $R_i^{[1]}$, and the degree $d^{[1]}$ of the error position polynomial is consequently increased by one. Furthermore, the corresponding assigned auxiliary polynomials are corrected via auxiliary operations. In accordance with the operation field marked by the reference numeral 5, the functional relationships:

$$R^{[1]}(X) = XR^{[1]}(X),$$

$$G^{[1]}(X) = XG^{[1]}(X),$$

$$R^{[2]}(X) = R_1^{[1]}R^{[2]}(X) - R_i^{[2]}R^{[1]}(X),$$

$$G^{[2]}(X) = R_1^{[1]}G^{[2]}(X) - R_i^{[2]}R^{[1]}(X),$$

$$d^{[1]} = d^{[1]} + 1. \tag{4}$$

hold in this case.

Since, however, the error position polynomial $G^{[1]}(X)$ is permitted to have at most the same degree by comparison with the error position auxiliary polynomial $G^{[2]}(X)$, an exchange of all correspondingly relevant register contents is carried out for the case in which increasing the degree $d^{[1]}$ of the error position polynomial $G^{[1]}(X)$ renders the said degree greater than the degree $d^{[2]}$ (reference numerals 6 and 7 in Figure 1).

If the output of a subsequent test (reference numeral 8 in Figure 1) is that the running variable i < n-1, not all coefficients $R_i$ have been processed yet. The running variable is increased in this case by 1 (reference numeral 9 in Figure 1) and the decoding mechanism is executed once again for the next coefficient $R_i^{[1]}$ (reference numeral 3 in Figure 1).

The part of the mechanism according to the invention which is described above therefore corresponds in the present exemplary embodiment essentially to the Berlekamp-Massey algorithm, which is known per se. Assuming that the total number of errors $\leq t$, the current error position polynomial $G^{[1]}(X)$ obtained at the end after the investigation of all the coefficients $R_1^{[1]}$ comprises the detected error positions, based on the transmission, as zero points of the polynomial.

The decoding is to be regarded as successful (reference numeral 10 in Figure 1) in this case when the number of the zero points of the error position polynomial $G^{[1]}(X)$ at the sampled positions $\alpha^0,.., \alpha^{n-1}$ corresponds to the associated degree $d^{[1]}$. Otherwise, decoding is held to be unsuccessful, and the decoding is continued by further reaching investigation of the error position polynomial $G^{[1]}(X)$ and of the error position auxiliary polynomial $G^{[2]}(X)$, taking account of erasures to be introduced.

It is firstly checked for this purpose whether the number of erasures already introduced has already reached the maximum number "max" of erasures. As already mentioned above, the maximum number of erasures can be specified individually and is yielded by a Reed-Solomon code as smaller than or equal to 2t. Since j=1 was set when initializing 2 the decoding mechanism and, as is to be seen in the case of the decision box marked by the reference numeral 11, the running variable j is used to check the number of erasures, the check for j is j: $j \leq max + 1$.

If the maximum number of erasures has already been introduced, and decoding has not succeeded, there is failure of decoding and the algorithm is aborted.

If the algorithm has found a solution for the decoding problem, in which case the maximum number of erasures has not yet been introduced, it is possible to carry out a GMD decoding. A further decoding solution is obtained with 2 erasures in each case. A list of decoding solutions is therefore present at the end of the decoding algorithm. The "best" solution is determined as the most likely one from this list with the aid of individual criteria.

If the maximum number of erasures has not yet been introduced, the error position polynomial $G^{[1]}$ at the respective sampled points $\alpha^0, ..., \alpha^{n-1}$ is investigated for zero points.

For this purpose, reliability information supplied by the A/D converter of the receiving device during sampling of the received word r is used to sort the sampled points $\alpha^0, ..., \alpha^{n-1}$ in accordance with their reliability.

Thereupon, the sampled point specified as the most unreliable is used to start a zero point investigation 12 of the error position polynomial $G^{[1]}(X)$.

The functional register operations essentially corresponding to the error position investigation of the syndrome polynomial $R^{[1]}(X)$ are subsequently carried out by introducing respective erasures at the corresponding sampled points.

If there is a zero point of the error position polynomial $G^{[1]}(X)$ at such a sampled point $\alpha^{1(j)}$, it therefore holds for the register operations, as is shown by the reference numeral 13 in Figure 1, that:

$$R^{[2]}(X) = (X-\alpha^{1(j)}) R^{[2]}(X),$$

$$G^{[2]}(X) = (X-\alpha^{1(j)}) G^{[2]}(X),$$

$$d^{[2]} = d^{[2]}+1. \tag{5}$$

If, by contrast, the result of the check at the corresponding sampled point $\alpha^{1(j)}$ is that the corresponding error position polynomial $G^{[1]}(\alpha^{1(j)})$ does not vanish, the functional relationships:

$$R^{[1]}(X) = (X-\alpha^{1(j)})R^{[1]}(X),$$

$$G^{[1]}(X) = (X-\alpha^{1(j)})G^{[1]}(X),$$

$$R^{[2]}(X) = G^{[1]}(\alpha^{1(j)})R^{[2]}(X) - G^{[2]}(\alpha^{1(j)})R^{[1]}(X),$$

$$G^{[2]}(X) = G^{[1]}(\alpha^{1(j)})G^{[2]}(X) - G^{[2]}(\alpha^{1(j)}) G^{[1]}(X),$$

$$d^{[1]} = d^{[1]}+1. \tag{6}$$

hold in this case in accordance with the operation box marked by the reference numeral 14.
A comparison 15 of the degrees $d^{[1]}$ and $d^{[2]}$ and, if appropriate, an exchange 16 of the register contents then follow in accordance with the steps which follow in the preceding investigation of the syndrome polynomial $R^{[1]}(X)$.
After increasing 17 the running variables j, an appropriate check is then made firstly in turn as to whether the decoding has succeeded, or whether, possibly, a maximum number of erasures has not yet been introduced, so that the error position polynomial $G^{[1]}$ is to be investigated at the correspondingly next sample point $\alpha^{1(j)}$.
After successful decoding with or without erasures, it is, finally, necessary to calculate the error values in a way known to the person skilled in the art. It holds in general that:

$$\Omega(X)(X^n-1)= G^{[1]}(X)E(X),$$

E(X) representing the error value polynomial to be calculated.
Solving for $\Omega(X)$ yields:

$$\Omega(X) := \frac{G^{[1]}(X)(\sum_{j=k}^{n-1} R_j X^j + P(X))}{X^n -1},$$

P(X) being a polynomial of degree (k-1) at most and being selected such that the division leaves no remainder, that is to say P(X) constitutes the unknown lower coefficient of the error value polynomial E(X). Furthermore, the rule

$$\Omega(X) := \frac{R^{[1]}(X)}{X^n}$$

can also be used at the end of successful decoding.
It holds for each zero point $z_j$ of the error position polynomial $G^{[1]}(X)$ that:

$$E(z_j) = \frac{n\Omega(z_j)}{z_j(G^{[1]}(X))'(Z_j)},$$

where $E(z_j)$ is the error value respectively corresponding to the error position $z_j$.

Since, furthermore it holds that

$$R^{[1]/[2]}(X) = \left( \sum_{l=k}^{n-1} R_l X^l \right) G^{[1]/[2]}(X)$$

it is necessary in each case, in order not to have to calculate $R^{[1]/[2]}(X)$ explicitly, to calculate only the coefficient $R_i^{[1]}$ of interest, which leads to a further simplification.

The additional, inventive introduction of erasures of genuine error positions is described below with the aid of an example of an errored information transmission in which an error-only decoding of the received word "r" leads to an incorrect result.

Let $\alpha = 5$ be selected as primitive element over the finite body with seven elements. The code used for channel coding may further be the (6,2) Reed-Solomon code which can therefore correct up to two errors.

Let the code polynomial used to form the code word be: $C(X)=3+6X$. The evaluation in X = 1,5,4,6,2,3, which corresponds to the sampled points $\alpha^j$ (where j = 0 to 5), yields a code word "c" with the transmission values $c_0 = 2$, $c_1 = 5$, $c_2 = 6$, $c_3 = 4$, $c_4 = 1$ and $c_5 = 0$. Let the received word "r" have the symbols $r_0 = 2$, $r_1 = 5$, $r_2 = 0$, $r_3 = 0$, $r_4 = 0$ and $r_5 = 0$.

Thus, one error more than can be corrected has appeared during the transmission. An error-only decoding will therefore, as expected, detect the first two points as error positions and supply the zero word as decoding result.

In accordance with the method according to the invention, it holds for the coefficients of the receiving polynomial $R_j$ for j = 0, ..., 5, after carrying out the Fourier transformation, that: $R_j = 6^{-1} (2*1+5*5^{-j})$, that is to say $(R_2, R_3, R_4, R_5) = (2, 3, 6, 1)$.

For the purpose of starting the implemented decoding mechanism, it holds in accordance with the previously described initialization that:

$$R^{[1]}(X) = 2X^2 + 3X^3 + 6X^4 + 1X^5,$$

$$R^{[2]}(X) = X^2,$$

$$i = 2,$$

$$j = 1,$$

$$d^{[1]} = 0,$$

$$d^{[2]} = 1,$$

$$G^{[1]}(X) = 1,$$

$$G^{[2]}(X) = 0.$$

It follows that the checking of the first coefficient of the syndrome polynomial, that is to say this is the coefficient $R_2^{[1]}$ for the initialized starting value i = 2, yields the value 2, that is to say a non-vanishing value. The operations to be carried out in accordance with the functional relationships (4) therefore yield:

$$R^{[1]}(X) = XR^{[1]}(X) = 2X^3+3X^4+6X^5+1X^6,$$

$$G^{[1]}(X) = XG^{[1]}(X) = X,$$

$$R^{[2]}(X) = R_2^{[1]}R^{[2]}(X) - R_2^{[2]}R^{[1]}(X) = 2X^2 - (2X^2 + 3X^3 + 6x^4 + 1X^5)$$
$$= 4X^3 + 1X^4 + 6X^5,$$

$$G^{[2]}(X) = R_2^{[1]}G^{[2]}(X) - R_2^{[2]}G^{[1]}(X) = 2*0-1*1 = 6 \text{ and}$$

$$d^{[1]} = 1.$$

The investigation of the coefficient $R_3^{[1]}$ yields the value 2 for i = 3 in the next step.
It therefore holds that:

$$R^{[1]}(X) = XR^{[1]}(X) = 2X^4 + 3X^5 + 6X^6 + 1X^7,$$

$$G^{[1]}(X) = XG^{[1]}(X) = X^2,$$

$$R^{[2]}(X) = R_3^{[1]}R^{[2]}(X) - R_3^{[2]}R^{[1]}(X)$$
$$= 2(4X^3 + 1X^4 + 6X+) - 4(2X^3 + 3X^4 + 6X^5 + 1X^6) = 4X^4 + 2X^5 + 3X^6,$$
$$= 4X^3 + 1X^4 + 6X^5,$$

$$G^{[2]}(X) = R_3^{[1]}G^{[2]}(X) - R_3^{[2]}G^{[1]}(X) = 2(6)-4X = 5+3X, \text{ and}$$

$$d^{[1]} = 2.$$

upon renewed application of the appropriate register operations.
Since $d^{[2]} > d^{[1]}$ at this point, the contents of the correspondingly assigned registers are consequently exchanged with one another, and therefore it holds that:

$$R^{[1]}(X) = 4X^4 + 2X^5 + 3X^6,$$

$$G^{[1]}(X) = 5+3X,$$

$$d^{[1]} = 1,$$

$$R^{[2]}(X) = 2X^4 + 3X^5 + 6X^6 + 1X^7,$$

$$G^{[2]}(X) = X^2, \text{ and}$$

$$d^{[2]} = 2.$$

For i=4 and $R_4^{[1]} = 4$, it holds correspondingly that:

$$R^{[1]}(X) = XR^{[1]}(X) = 4X^5 + 2X^6 + 3X^7,$$

$$G^{[1]}(X) = XG^{[1]}(X) = 5X + 3X^2,$$

$$R^{[2]}(X) = R_4^{[1]}R^{[2]}(X) - R_4^{[2]}R^{[1]}(X)$$
$$= 4(2X^4 + 3X^5 + 6X^6 + 1X^7) - 2(4X^4 + 2X^5 + 3X^6) = X^5 + 4X^6 + 4X^7,$$

$$G^{[2]}(X) = R_4^{[1]}G^{[2]}(X) - R_4^{[2]}G^{[1]}(X) = 4X^{[2]} - 2(3X + 5) = 4 + X + 4X^2,$$

$$d^{[1]} = 2;$$

and for i = 5 given $R_5^{[1]} = 4$, that:

$$R^{[1]}(X) = XR^{[1]}(X) = 4X^6 + 2X^7 + 3X^8,$$

$$G^{[1]}(X) = XG^{[1]}(X) = 5X^2 + 3X^2,$$

$$R^{[2]}(X) = R_5^{[1]}R^{[2]}(X) - R_5^{[2]}R^{[1]}(X)$$
$$= 4(X^5 + 4X^6 + 4X^7) - 1(4X^5 + 2X^6 + 3X^7) = 6X^7,$$

$$G^{[2]}(X) = R_5^{[1]}G^{[2]}(X) - R_5^{[2]}G^{[1]}(X)$$
$$= 4(4 + X + 4X^2) - 1(5X + 3X^2) = 2 + 6X + 6X^2,$$

and

$$d^{[1]} = 3.$$

Since, in turn, this results in $d^{[2]} > d^{[1]}$, the contents of the correspondingly assigned registers are exchanged with one another a further time, and so it holds that:

$$R^{[1]}(X) = 6X^7,$$

$$G^{[1]}(X) = 2 + 6X + 6X^2,$$

$$d^{[1]} = 2,$$

$$R^{[2]}(X) = 4X^6 + 2X^7 + 3X^8,$$

$$G^{[2]}(X) = 5X^2 + 3X^3, \text{ and}$$

$$d^{[2]} = 3.$$

Since the error position polynomial $G^{[1]}(X) = 6X^2+6X+2$ has the 2 zero points at X=1 and X=5, the error-only decoding would, as already mentioned above, recognize the first two positions of the received word r as error positions, and would therefore, as expected, supply the zero word as result at this point.

However, the aim with the present example is to show that the code word actually sent can be obtained by erasing two real error positions.

In the case of a corresponding sorting of the sampled points in terms of rising reliability, erasures are subsequently introduced into the sampled points detected as unreliable, erasures being inserted at X=2 and X=4 in the present example.

Checking the error position polynomial $G^{[1]}(X)$ at the point X=2: $G^{[2]}$ at the point X = 2 for j=1 yields firstly: $G^{[1]}(2) = 6*4+6*2*2=3$. $G^{[2]}(2) = 2$ for the corresponding error position auxiliary polynomial.

Upon introducing the erasure at X=2, the functional relationships (6) applied in this case yield the following register operations to be carried out:

$$R^{[1]}(X) = (X-2)R^{[1]}(X) = (X-2)6X^7 = 2X^7 + 6X^8,$$

$$G^{[1]}(X) = (X-2)G^{[1]}(X) = (X-2)(2+6X+6X^2) = 3+4X+X^2+6X^3,$$

$$\begin{aligned} R^{[2]}(X) &= G^{[1]}(2)R^{[2]}(X) - G^{[2]}(2)R^{[1]}(X) \\ &= 3(4X^6+2X^7+3X^8) - 2(6X^7) = 5X^6+X^7+2X^8, \end{aligned}$$

$$\begin{aligned} G^{[2]}(X) &= G^{[1]}(2)G^{[2]}(X) - G^{[2]}(2)G^{[1]}(X) \\ &= 3(5X^2+3X^3) - 2(2+6X+6X^2) = 3+2X+3X^2+2X^3, \end{aligned}$$

and

$$d^{[1]} = 3.$$

Thus, for j=2 the error position polynomial $G^{[1]}(X)$ in X=4 is:
$G^{[1]}(4) = 3+4*4+2+6 = 6$. The corresponding error position auxiliary polynomial $G^{[2]}(4) = 5$.

The following operations apply correspondingly with reference to the second erasure to be introduced at X=4:

$$R^{[1]}(X) = (X-4)R^{[1]}(X) = (X-4)(2X^7+6X^8),$$

$$G^{[1]}(X) = (X-4)G^{[1]}(X) = (X-4)(3+4X+X^2+6X^3),$$

$$\begin{aligned} R^{[2]}(X) &= G^{[1]}(4)R^{[2]}(X) - G^{[2]}(4)R^{[1]}(X) \\ &= 6(5X^6+X^7+2X^8) - 5(2X^7+6X^8) = 2X^6+3X^7+3X^8, \end{aligned}$$

$$\begin{aligned} G^{[2]}(X) &= G^{[1]}(4)G^{[2]}(X) - G^{[2]}(4)G^{[1]}(X) \\ &= 6(3+2X+3X^2+2X^3) - 5(3+4X+X^2+6X^3) = 3+6X+6X^2+3X^3, \end{aligned}$$

and

$$d^{[1]} = 4.$$

Since $d^{[1]} = 4$ and is therefore greater than $d^{[2]} = 3$, the register contents must consequently be changed in turn, and so it holds that:

$$R^{[1]} (X) = 2X^6 + 3X^7 + 3X^8,$$

$$G^{[1]} (X) = 3 + 6X + 6X^2 + 3X^3,$$

$$d^{[1]} = 3.$$

Since $G^{[1]} (X) = 3 + 6X = 6X^2 + 3X^3 = 3 (X-2) (X-4) (X-6)$ and, furthermore, the number of these zero points of $G^{[1]}$ at the sampled points corresponds to the degree $d^{[1]}$, the decoding is regarded as successful, and the error position still lacking is found at $X = 6$.

The error values still to be calculated are therefore yielded from $\Omega (X)$ as follows:

$$\Omega(X) = (R^{[1]}(X))/X^6 = 2 + 3X + 3X^2,$$

and it therefore holds for the error values at $X = 2$, $X = 4$ and $X = 6$ that:

$$E(2) = \frac{6\Omega(2)}{2(G^{[1]}(X))'(2)} = 6,$$

$$E(4) = \frac{6\Omega(4)}{4(G^{[1]}(X))'(4)} = 1,$$

and

$$E(6) = \frac{6\Omega(6)}{6(G^{[1]}(X))'(6)} = 3.$$

As already shown above, r = c + e holds in a general way for the relationship between a sent code word "c" and the word "r" which is received after the transmission via a disturbed channel and differs from the sent code word c by the error word "e".

The sent code word "c" is therefore yielded after substituting the calculated error values in e via the relationship r-e = c, that is to say c = (2,5,0,0,0,0)-(0,0,1,3,6,0) = (2,5,6,4,1,0).

**Claims**

1. Method for decoding in a receiving device for a digital transmission system, in which, for the purpose of transmitting data, channel coding is undertaken by means of an algebraic block code with the aid of the following steps:

   - sampling a received word (r) at predeterminable interpolation points ($\alpha^0$, ..., $\alpha^{n-1}$) in order to obtain the symbols ($r^0$, ..., $r^{n-1}$) contained in the received word,
   - obtaining coefficients ($R_1$) for the purpose of forming a syndrome polynomial ($R^{[1]} (X)$) by applying an interpolation, preferably a Fourier transformation to the symbols ($r^0$, ...,. $r^{n-1}$), and
   - carrying out an error position search on the basis of the syndrome polynomial ($R^{[1]} (X)$) with the defined introduction of erasures.

**2.** Method according to Claim 1, **characterized in that** carrying out the error position search includes, in a first stage, error-only decoding, based on the syndrome polynomial ($R^{[1]}$ (X)) in order to obtain an error position polynomial ($G^{[1]}$ (X)), functionally connected to the polynomial ($R^{[1]}$ (X)), and an error position auxiliary polynomial ($G^{[2]}$ (X)) and, in a second stage, carrying out a zero point investigation based on the error position polynomial ($G^{[1]}$ (X)) and the error position auxiliary polynomial ($G^{[2]}$ (X)) with the defined introduction of erasures.

**3.** Method according to Claim 2, **characterized in that** an algebraic decoding method is used for the error-only decoding.

**4.** Method according to Claim 2 or 3, **characterized in that** the Berlekamp-Massey method is applied for the error-only decoding.

**5.** Method according to one of Claims 1 to 4, **characterized in that** the symbol positions of the received word are presorted with reference to their reliability for the purpose of the defined introduction of the erasures.

**6.** Method according to one of Claims 1 to 5, **characterized in that** the received symbols ($r^0$, ..., $r^{n-1}$) are sorted in terms of rising reliability in response to the reliability information generated by the receiving device and successive erasures are introduced at the interpolation points.

**7.** Method according to one of Claims 1 to 6, **characterized in that** individual decoding results are buffered and, if a maximum available number of erasures has not yet been reached, are made available to a GMD.

**8.** Method according to one of Claims 1 to 6, **characterized in that** the algorithm is aborted with decoding failure after the introduction of a maximum available number of erasures in the case of unsuccessful decoding.

**9.** Receiving device of a digital transmission system in which, for the purpose of transmitting data, channel coding is undertaken by means of an algebraic block code comprising

- a device for sampling a received word (r) with symbols ($r^0$,..., $r^{n-1}$) at predeterminable interpolation points ($\alpha^0$, ..., $\alpha^{n-1}$),
- a decoding device having
    devices for obtaining coefficients ($R_1$) for the purpose of forming a syndrome polynomial ($R^{[1]}$ (X)) by applying an interpolation, in particular a Fourier transformation to the symbols ($r^0$, ...,. $r^{n-1}$), and
    devices for carrying out an error-only decoding, based on the syndrome polynomial ($R^{[1]}$ (X)), in order to obtain an error position polynomial ($G^{[1]}$ (X)) functionally connected to the polynomial $r^{[1]}$(X)) and based thereon, in order to carry out a zero point investigation with the defined introduction of erasures.

**10.** Receiving device according to Claim 9, **characterized by** a device for generating reliability information with reference to the positions of the symbols ($r^0$,...,. $r^{n-1}$) of the received word (r) .

**11.** Receiving device according to Claim 9 or 10, **characterized in that** the decoding device is adapted for decoding Reed-Solomon codes and/or their related codes such as, for example, a BCH code.

**12.** Receiving device according to Claim 9, 10 or 11, **characterized in that** the block code used for the purpose of channel coding is part of a concatenated code.

**13.** Computer program for carrying out a method according to one of Claims 1 to 8, in particular inside a receiving device according to one of Claims 9 to 12.

**FIG. 1**

EP 1 246 370 A1

r →

Box 1 — Fourier transform:
$$R_i = \frac{1}{n} \sum_{j\text{-}0}^{n-1} \alpha^{-ij} r_j$$
$$k \le i \le n-1$$

Box 2:
$$R^{[1]}(X) := \sum_{p=k}^{n-1} R_p X^p$$
$$R^{[2]}(X) := X^k \quad i:=k \quad j:=1$$
$$d^{[1]} := 1 \quad G^{[1]}(X) := 1$$
$$d^{[2]} := 0 \quad G^{[2]}(X) := 0$$

Decision 3: $R_i^{[1]} = 0$

— Yes →

Box 5:
$$R^{[1]}(X) = XR^{[1]}(X)$$
$$G^{[1]}(X) = XG^{[1]}(X)$$
$$R^{[2]}(X) = R_i^{[1]}R^{[2]}(X) - R_i^{[2]}R^{[1]}(X)$$
$$G^{[2]}(X) = R_i^{[1]}G^{[2]}(X) - R_i^{[2]}G^{[1]}(X)$$
$$d^{[1]} = d^{[1]} + 1$$

— No →

Box 4:
$$R^{[2]}(X) = XR^{[2]}(X)$$
$$G^{[2]}(X) = XG^{[2]}(X)$$
$$d^{[2]} = d^{[2]} + 1$$

Decision 6: $d^{[1]} > d^{[2]}$

— Yes →

Box 7: change $R^{[1]}, G^{[1]}, d^{[1]}$ with $R^{[2]}, G^{[2]}, d^{[2]}$

— No

Decision 8: $i = n-1$

— No → Box 9: $i = i+1$

— Yes

EP 1 246 370 A1

$j=j+1$ — 17

Error position-and erasure polynomial $G^{[1]}(X)$

$\xleftarrow{Yes}$ Succesful decoding — 10

*Yes*

*No*

Failure of decoding $\xleftarrow{Yes}$ $j = max+1$ — 11

*No*

14

$R^{[1]}(X) = (X-\alpha^{1(j)})R^{[1]}(X)$

$G^{[1]}(X) = (X-\alpha^{1(j)})G^{[1]}(X)$

$R^{[2]}(X) = G^{[1]}(\alpha^{1(j)})R^{[2]}(X)-G^{[2]}(\alpha^{1(j)})R^{[1]}(X)$

$G^{[2]}(X) = G^{[1]}(\alpha^{1(j)})G^{[2]}(X)-G^{[2]}(\alpha^{1(j)})G^{[1]}(X)$

$d^{[1]} = d^{[1]}+1$

$\xleftarrow{Yes}$ $G^{[1]}(\alpha^{1(j)})=0$ — 12

*No*

15

$d^{[1]}>d^{[2]}$ $\xrightarrow{Yes}$ change $R^{[1]}, G^{[1]}, d^{[1]}$ with $R^{[2]}, G^{[2]}, d^{[2]}$ — 16

*No*

$R^{[2]}(X) = (X-\alpha^{1(j)})R^{[2]}(X)$

$G^{[2]}(X) = (X-\alpha^{1(j)})G^{[2]}(X)$

$d^{[2]} = d^{[2]}+1$ — 13

**FIG. 1(contd.)**

# FIG. 2

Source → (255,223) RS-Encoder → Interleaver → Convolutional Code R=1/2, M=6 → ⊕ ← Noise

Sink ← RS-Decoder ← Deinterleaver ← Viterbi Decoder ←

Outer Code

Inner Code

AWGN Channel
BPSK
8 Level
Quantization

EP 1 246 370 A1

# FIG. 3

A)

| information | redundancy |
|---|---|

B)

**European Patent Office**

**EUROPEAN SEARCH REPORT**

Application Number

EP 01 30 2867

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,X | SORGER U K: "A NEW REED-SOLOMON CODE DECODING ALGORITHM BASED ON NEWTON'S INTERPOLATION" IEEE TRANSACTIONS ON INFORMATION THEORY, IEEE INC. NEW YORK, US, vol. 39, no. 2, 1 March 1993 (1993-03-01), pages 358-365, XP000377699 ISSN: 0018-9448 | 1-6 | H03M13/15 H03M13/45 |
| A | * paragraph [0II.] * <br> * paragraph [VI.B] * | 7-13 | |
| D,A | HAGENAUER J, OFFER E, PAPKE L: "Improving the standard coding system for deep space missions" IEEE INTERNATIONAL CONFERENCE ON COMMUNICATIONS, vol. 2, 23 May 1993 (1993-05-23) - 26 March 1993 (1993-03-26), pages 1092-1097, XP002174972 Geneva, Switzerland * the whole document * | 1-3,5-13 | |
| | | | **TECHNICAL FIELDS SEARCHED (Int.Cl.7)** |
| A | KOTTER R: "Fast generalized minimum-distance decoding of algebraic-geometry and Reed-Solomon codes " IEEE TRANSACTIONS ON INFORMATION THEORY, vol. 42, May 1996 (1996-05), pages 721-737, XP002174973 USA * the whole document * | 1-6, 9-11,13 | H03M |
| A | FORNEY J G D: "Generalized minimum distance decoding" IEEE TRANS. INFORM. THEORY, vol. IT12, April 1966 (1966-04), pages 125-131, XP002174974 USA | | |

The present search report has been drawn up for all claims

| Place of search | Date of completion of the search | Examiner |
|---|---|---|
| THE HAGUE | 15 August 2001 | Ogor, M |

EPO FORM 1503 03.82 (P04C01)